Europäisches Patentamt

European Patent Office

Office européen des brevets

(11) Veröffentlichungsnummer: **0 306 676 B1**

(12) **EUROPÄISCHE PATENTSCHRIFT**

(45) Veröffentlichungstag der Patentschrift: **07.10.92**

(21) Anmeldenummer: **88111872.3**

(22) Anmeldetag: **22.07.88**

(51) Int. Cl.⁵: **H01L 21/00**, G01B 11/06

(30) Priorität: **13.08.87 DE 3727027**

(43) Veröffentlichungstag der Anmeldung:
**15.03.89 Patentblatt 89/11**

(45) Bekanntmachung des Hinweises auf die
Patenterteilung:
**07.10.92 Patentblatt 92/41**

(84) Benannte Vertragsstaaten:
**DE FR GB IT**

(56) Entgegenhaltungen:
**FR-A- 2 531 938**
**US-A- 4 490 087**
**US-A- 4 490 612**

**JOURNAL OF PHYSICS. E. SCIENT. INSTRU-
MENTS, Band 5, Nr. 9, September 1972, Seiten 856-857; D.K. SCHRODER et al.: "An optical thickness gauge for semiconductors"**

**"Physics of Semiconductor devices", 2. Auflage, Herausgegeben von S.M. Sze, John Wiley & Sons 1981, Seiten 39-42; "Introduction
to Solid State Physics", 2. Auflage, C. Kittel,
John Wiley & Sons 1956, Seite 351**

(54) **Vorrichtung zur Identifikation von unterschiedlichen Halbleiterscheiben.**

(73) Patentinhaber: **SIEMENS AKTIENGESELL-
SCHAFT**
**Wittelsbacherplatz 2**
**W-8000 München 2(DE)**

(72) Erfinder: **Hoerschelmann, Konstantin,
Dipl.-Phys**
**Langenstegham 6**
**W-8261 Mettenheim(DE)**
Erfinder: **Scharf, Ludwig, Dipl.-Phys**
**Montgelasstrasse 33**
**W-8000 München 80(DE)**
Erfinder: **Völkl, Johannes, Dr. Dipl.-Ing.**
**Würzburgring 39**
**W-8520 Erlangen(DE)**
Erfinder: **Weidlich, Herbert, Dr. Dipl.-Phys.**
**Bajuwarenstrasse 13**
**W-8029 Sauerlach(DE)**

## Beschreibung

Die Erfindung betrifft eine Vorrichtung zur Identifikation von unterschiedlichen Halbleiterscheiben nach dem Oberbegriff des Anspruchs 1.

Bei einer bekannten Vorrichtung zur optischen Dickenmessung von Silizium-Halbleiterscheiben wird die Transmission von Licht gemessen, dessen Wellenlänge etwas unterhalb der Bandlücke des Halbleitermaterials liegt (Journal of Physics E: Scientific Instruments, Band 5, Nr. 9, Sept. 1972, Seiten 856 - 857).

Es ist ferner bekannt, daß der Absorptionskoeffizient eines Halbleiters von der Bandlücke des Halbleitermaterials abhängt. Die Messung des Absorptionskoeffizienten dient deshalb auch zur Bestimmung der Energieband-Lücke von Halbleitern ("Physics of Semiconductor Devices", 2.Auflage, herausgegeben von S.M. Sze, John Wiley & Sons, 1981, Seiten 39 - 42, und "Introduction to Solid State Physics", 2. Auflage, C. Kittel, John Wiley & Sons, 1956, Seite 351).

In der Halbleitertechnologie werden mehr und mehr teure Geräte benötigt, deren hohe Kosten eine gemeinsame Nutzung dieser teuren Geräte in verschiedenen Prozeßlinien zur Herstellung von Halbleiterbauelementen erfordern. Zum Beispiel werden teure Geräte zur Ionenimplantation sowohl für die Herstellung von Silizium-Bauelementen als auch zur Herstellung von Gallium-Arsenid (GaAs)-Bauelementen benutzt. Das Fehllaufen von Gallium-Arsenid-Scheiben in eine Silizium-Prozeßlinie birgt erhebliche Risiken der Kontamination und der Gesundheits- und Umweltschädigung. Daher kommt es entscheidend darauf an, eine Methode zu finden, um einem Los von Silizium-Scheiben fehlerhaft zugeordnete Gallium-Arsenid-Halbleiterscheiben (Wafer) sicher und einfach zu identifizieren. Allgemein gesprochen, soll aus einem Los von Halbleiterscheiben einer bestimmten ersten Sorte jede Halbleiterscheibe einer von der ersten Sorte verschiedenen Sorte ausgeschieden werden können.

Der vorliegenden Erfindung liegt daher die Aufgabe zugrunde, eine Vorrichtung der eingangs genannten Art anzugeben, mit der aus einer Gruppe von bestimmten Halbleiterscheiben jede nicht zu dieser Gruppe gehörende Halbleiterscheibe einer anderen Art ausgeschieden werden kann.

Diese Aufgabe wird durch eine Vorrichtung nach Anspruch 1 gelöst.

Ausgestaltungen und Vorteile der Erfindung sind in den Unteransprüchen, der Beschreibung und der Zeichnung dargestellt.

Vorteilhafterweise wird eine Vorrichtung verwendet, die eine Kombination aus einer mechanischen Lehre und einer Infrarot-Transmissions-Meßeinrichtung darstellt, welches Gerät, an die üblichen Transporthorden für Halbleiterscheiben angesetzt, die Kontrolle der in einer Transporthorde befindlichen Halbleiterscheiben in wenigen Sekunden durchzuführen gestattet.

Ausführungsbeispiele der Erfindung werden anhand der Zeichnung näher erläutert.

FIG 1    erläutert das Prinzip einer Vorrichtung nach der Erfindung, bei dem eine mechanische Lehre verwendet wird.

FIG 2 bis 4    erläutern verschiedene Möglichkeiten einer Infrarot-Transmissionsmessung nach der Erfindung.

FIG 5 bis 7    zeigen Einzelheiten einer Infrarot-Transmissions-Meßeinrichtung nach der Erfindung.

FIG 8    zeigt eine Infrarot-Transmissions-Meßeinrichtung nach der Erfindung.

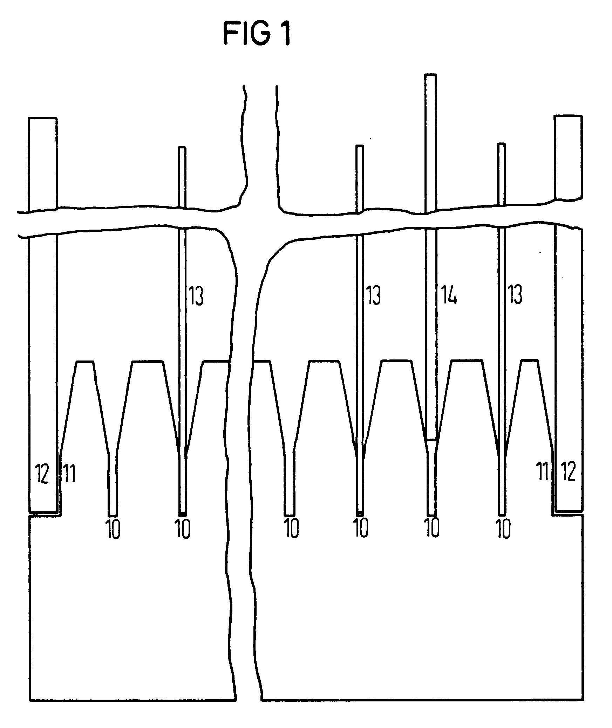

FIG 1 erläutert das Prinzip einer Vorrichtung zur Identifikation von unterschiedlichen Halbleiterscheiben 13, 14 in einer Transporthorde mit einer an die Transporthorde passenden mechanischen Lehre mit Schlitzen 10, die schmaler als die untere Toleranzdicke einer ersten bestimmten Halbleiterscheibe 14 und breiter als die obere Toleranzdicke einer zweiten bestimmten Halbleiterscheibe 13 sind.

Gallium-Arsenid-Scheiben 14 werden im allgemeinen in größeren Standarddicken geliefert als Silizium-Scheiben 13. So haben zum Beispiel 3-Zoll-Scheiben von Silizium-Halbleiterscheiben eine Dicke von 380 + -25 $\mu$m und 3-Zoll-Scheiben von Gallium-Arsenid-Halbleiterscheiben eine Dicke von 625 + -25 $\mu$m. Mit einer mechanischen Lehre nach FIG 1, die eine Reihe von Schlitzen 10 mit einer Breite von 420 $\mu$m in einem Abstand der Schlitze 10 von 4,76 mm aufweist, können die Gallium-Arsenid-Halbleiterscheiben 14 von den Silizium-Halbleiterscheiben 13 unterschieden werden. Der Abstand zwischen den Schlitzen 10 von 4,76 mm entspricht dem Abstand der Halbleiterscheiben 13, 14 in einer Standard-Halbleiterscheiben-Transporthorde. Eine mechanische Lehre nach FIG 1 kann z. B. in Form einer Kunststoffleiste ausgebildet sein. FIG 1 zeigt die Seitenansicht einer solchen Kunststoffleiste. Vorteilhafterweise besitzt diese Kunststoffleiste zusätzlich Anschlagflächen 11, die mit den Stirnflächen 12 der Halbleiterscheiben-Transporthorde fitten. Vorteilhafterweise laufen die Schlitze 10 keilförmig aus, damit die Halbleiterscheiben 13 in die Schlitze 10 hineingeführt werden. Halbleiterscheiben 13 mit einer Dicke von weniger als 420 $\mu$m rutschen in die Schlitze 10 hinein, während Halbleiterscheiben 14 mit einer Dicke von mehr als 420 $\mu$m beim Anlegen der mechanischen Lehre nach oben gedrückt werden und bei Betrachtung der Transporthorde von oben leicht als überstehend ausgemacht und aus der Transporthorde ausgeschieden werden können.

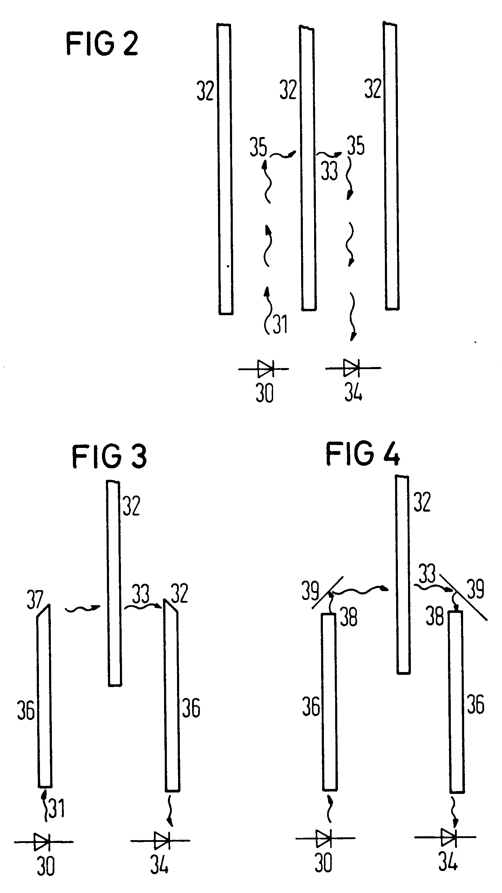

Aufgrund verschiedener Umstände läßt sich der Fall nicht ausschließen, daß Silizium-Halbleiterscheiben dicker als die Standarddicke von Silizium-Halbleiterscheiben ausfallen oder daß dünnere Gallium-Arsenid-Halbleiterscheiben vorkommen, als üblicherweise gemäß der Standarddicke von Gallium-Arsenid-Halbleiterscheiben zu erwarten ist. Beispielsweise können auf Silizium-Halbleiterscheiben sehr dicke Epischichten aufgebracht sein. Daher wird alternativ und/oder zusätzlich zur Verwendung einer mechanischen Lehre gemäß FIG 1 die Durchführung einer Infrarottransmissionsmessunggemäß den FIG 2 bis 8 vorgeschlagen.

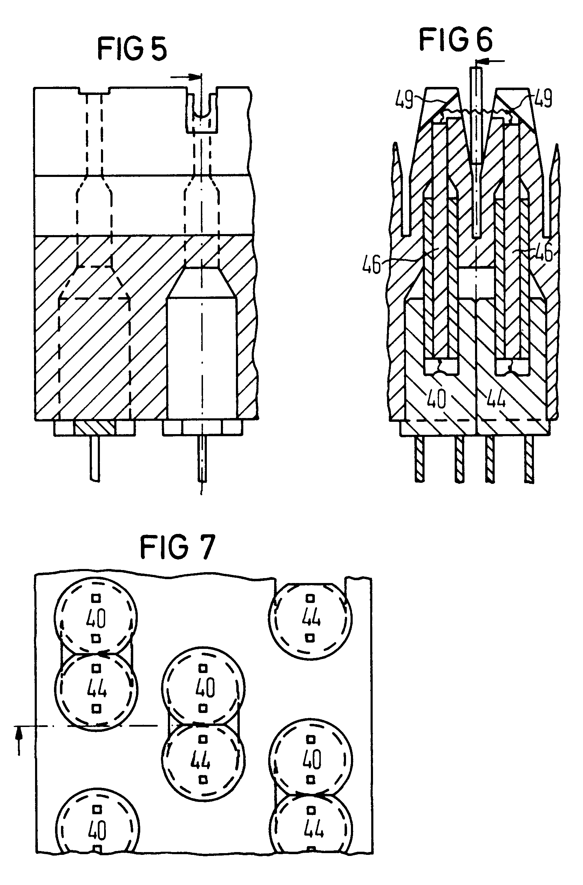

FIG 2 bis 4 erläutern verschiedene Möglichkeiten von Infrarot-Transmissionsmessungen. Silizium absorbiert Lichtquanten, deren Energie größer als 1,12 eV, d. h. deren Wellenlänge kleiner als 1100 nm ist. Gallium-Arsenid hingegen absorbiert wegen der größeren Energieband-Lücke von Gallium-Arsenid erst Lichtquanten, deren Energie größer als 1,42 eV, d. h. deren Wellenlänge kleiner als 870 nm ist. Zwischen den Wellenlängen von 870 und 1100 nm wird also Infrarotstrahlung von Silizium zu 100 % absorbiert und von undotiertem Gallium-Arsenid zumindest teilweise durchgelassen. Dotierte Gallium-Arsenid Bereiche haben gegenüber undotiertem Gallium-Arsenid eine etwas verringerte Transmission. Die Zusammenhänge zwischen optischer Absorption und Dotierungsgrad von Galliumarsenid können beispielsweise einer Veröffentlichung aus Physical Review, Band 114, Seite 59 (1959) entnommen werden. Bei den Gallium-Arsenid-Scheiben der Mikrowellen-Feldeffekttransistoren-Technologie und der IC-Technologie sind die Substrate der Gallium-Arsenid-Halbleiterscheiben undotiert bzw. Cr-dotiert und zeigen schon bei einer Wellenlänge von 950 nm eine Transmission 5 bis 10 %. Die Absorption von auf die Halbleiterscheiben aufgebrachten elektrisch leitenden Schichten, deren Dicke im $\mu$m-Bereich liegt, ist dabei vernachlässigbar. Sollen lichtemittierende Dioden (LED) gefertigt werden, so sind auch die zugehörigen Substrate der Gallium-Arsenid-Halbleiterscheiben dotiert. Für solche dotierte Substrate müssen unter Umständen für eine Infrarot-Transmissionsmessung zur Identifikation von unterschiedlichen Halbleiterscheiben längere Wellenlängen nahe 1100 nm verwendet werden. Jedenfalls kann grundsätzlich durch Messung der Infrarot-Transmission zwischen Silizium-Scheiben und Gallium-Arsenid-Scheiben unterschieden werden. Silizium besitzt für Wellenlängen kleiner als 1100 nm eine Transmission von weniger als $10^{-4}$, wohingegen Gallium-Arsenid für Wellenlängen kleiner als 1100 nm eine Transmission von mehr als 1 % aufweist, unabhängig davon, ob Gallium-Arsenid dotiert oder undotiert ist. Dieser physikalische Unterschied in der Transmission von Silizium und Gallium-Arsenid für Wellenlängen kleiner als 1100 nm wird auf Halbleiterscheiben angewandt, die in einer Transporthorde stehen. Als eine Transporthorde kann z. B. eine Transporthorde der Fa. Fluoware verwendet werden. FIG 2 zeigt eine Prinzipskizze. Hierbei beträgt der gegenseitige Abstand der Halbleiterscheiben 32 nur ca. 4 mm. Eine Vorrichtung zur Durchführung eines Verfahrens benötigt Mittel 35, um die von einem Infrarot-Sender 30 ausgesandte Infrarot-Strahlung 31 zur Durchstrahlung einer Halbleiterscheibe 32 zu veranlassen und nach der Durchstrahlung dieser Halbleiterscheibe 32 auf einem Detektor 34 auftreffen zu lassen. Beispielsweise können die Mittel 35 dazu benutzt werden, um die von einem Infrarot-Sender 30 ausgesandte Infrarot-Strahlung 31 von außerhalb der Transporthorde zwischen zwei Halbleiterscheiben 32 einzuführen, dort zur Durchstrahlung einer Halbleiterscheibe 32 senkrecht umzulenken, hinter der Scheibe den durchgelassenen Strahl 33 nochmals senkrecht umzulenken, um ihn einem Detektor 34 außerhalb des Transporthorden-Bereichs zuzuführen. Die Führung der Infrarotstrahlung kann in Lichtleitfasern 36 erfolgen. Die 90°-Umlenkung der Infrarotstrahlung kann durch Abschrägen des Endes 37 der Lichtleitfaser 36 unter 45° (FIG 3) oder durch Anbringen von 45°-Spiegeln 39 vor den senkrecht zur optischen Achse abgeschnittenen Faserenden 38 (FIG 4) erfolgen. Die Erzeugung, Führung, Umlenkung und die Detektion der Infrarotstrahlung kann in mannigfaltiger Weise erfolgen. Wichtig ist nur, daß die Infrarotstrahlung durch eine Halbleiterscheibe 32 hindurch geschickt wird und daß hinter dieser Halbleiterscheibe 32 die zugehörige Transmission gemessen wird.

FIG 5 bis 7 zeigen eine weitere Ausführungsform einer Transmissions-Meßeinrichtung. Dabei sind mehrere solcher anhand der FIG 2 bis 4 erläuterten Transmissionsstrecken angeordnet. Am besten wird für jeden Halbleiterscheibenplatz in der Transporthorde je eine Transmissionsstrecke vorgesehen, so daß alle Halbleiterscheiben in der Transporthorde durch einmaliges Anlegen der Infrarottransmissions-Meßeinrichtung kontrolliert werden können. Die vom Sender 40, etwa einer Infrarot-Sendediode SFH 450 (LL-Version) der Fa. Siemens ausgesandte Infrarotstrahlung von 950 nm Wellenlänge wird durch die ummantelte Kunststoff-Lichtleichtfaser 46 zwischen die Halbleiterscheiben eingeführt, dort durch die Spiegel 49 zweimal um 90° umgelenkt und wieder durch eine Lichtleitfaser 46 dem Detektor 44, beispielsweise einer Infrarot-Empfangsdiode SFH 250 (LL-Version) der Fa. Siemens zugeführt. Die beschriebenen Elemente des Lichtweges können in einen Kunststoffkörper mit den Abmessungen der in FIG 1 beschriebenen mechanischen Lehre eingelagert werden. Die Transmissionsstrecken können jedoch auch ohne zusätzliche Kombination mit einer mechanischen Lehre verwendet werden. Damit ist eine Transmissions-Meßeinrichtung für unterschiedliche Dicken von zu messenden Halbleiterscheiben in flexibler Weise verwendbar.

In FIG 6 ist dargestellt, daß eine Gallium-Arsenid-Scheibe 42 schon aufgrund der Funktion der mechanischen Lehre ausgeschieden wird.

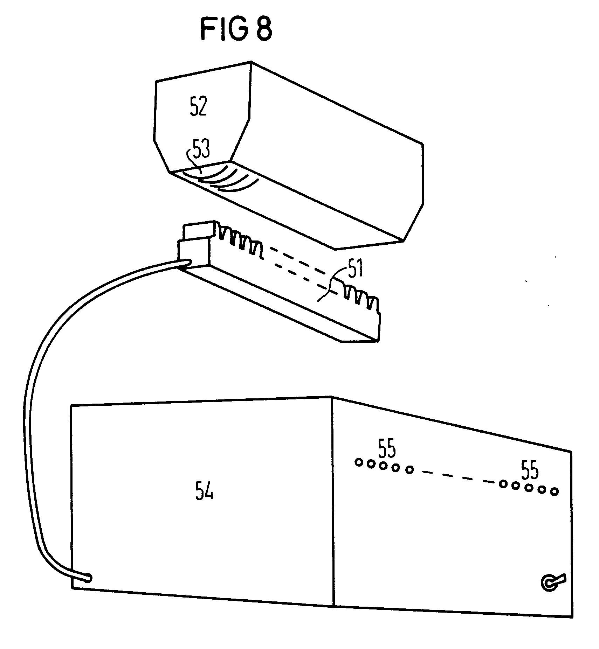

FIG 8 zeigt eine Infrarottransmissions-Meßeinrichtung in Kombination mit einer mechanischen Lehre.

Das Gerät nach FIG 8 hat die Aufgabe, Gallium-Arsenid-Scheiben in einer Transporthorde mit Silizium-Scheiben sicher aufzufinden. Das Gerät nach FIG 8 besteht aus einem kammförmigen Detektor 51 ähnlich einer Vorrichtung nach den FIG 5 bis 7, der so an die Transporthorde 52 angelegt wird, daß die Zinken des kammförmigen Detektors 51 zwischen die in der Transporthorde 52 befindlichen Halbleiterscheiben 53 eingreifen, und einem Ansteuergerät 54 zum Ansteuern des Detektors 51. Das Ansteuergerät 54 hat eine Reihe von Leuchtanzeigen 55, und zwar für jeden Halbleiterscheibenplatz in der Transporthorde 52 eine jeweils zugehörige Leuchtanzeige 55.

Beim Anlegen des Detektorkammes 51 an die Transporthorde 52 rutschen die in der Transporthorde 52 befindlichen Halbleiterscheiben 53 in die dafür vorgesehenen Schlitze des Detektorkammes 51. Lediglich diejenigen Scheiben, die die Dickentoleranz der Schlitze des Detektorkammes 51 nach oben hin überschreiten, können nicht bis zum Boden der Schlitze des Detektorkammes 51 rutschen, sondern werden schon von der keilförmigen Erweiterung der Schlitze des Detektorkammes 51 erfaßt und nach oben gedrückt und sind daher bei Betrachtung der Transporthorde 52 von oben her aufgrund der Funktion der mechanischen Lehre als anomale Scheiben erkennbar.

Nach Anlagen der Infrarottransmissions-Meßeinrichtung an die zugehörigen Anschläge der Transporthorde 52 können alle Transmissionsstrecken durch eine geeignete elektrische Schaltung automatisch abgefragt werden. Dies kann beispielsweise durch pulsmäßiges Ansteuern der ensprechenden Infrarot-Sendediode und durch Festhalten des zugehörigen Hubes im Signal des zugehörigen Empfängers durch eine mit dem Ansteuerimpuls synchronisierte Sample-and-Hold-Schaltung geschehen.

Überschreitet dieser Hub eine vorher einzustellende Schwelle entsprechend einigen Promille des vollen Signals bei leerem Scheibenplatz, so wird die zugehörige Leuchtanzeige 55 aufgrund der Transmissionskontrollfunktion ausgelöst.

## Patentansprüche

1. Vorrichtung zur Identifikation von unterschiedlichen Halbleiterscheiben (13, 14) in einer Transporthorde, **gekennzeichnet durch** die Kombination der die Halbleiterscheiben enthaltenden Transporthorde mit einer an die Transporthorde passenden mechanischen Lehre (51) mit Schlitzen (10), die sowohl schmaler als die untere Toleranzdicke einer ersten Halbleiterscheibensorte (14) als auch breiter als die obere Toleranzdicke einer zweiten Halbleiterscheibensorte (13) sind, in der Weise, daß die in der Transporthorde befindlichen Halbleiterscheiben (13, 14) der zweiten Halbleitersorte in die genannten Schlitze (10) der angelegten Lehre (51) rutschen.

2. Vorrichtung nach Anspruch 1, wobei die Halbleiterscheiben aus unterschiedlichem Material bestehen, von denen ein erstes Material eine größere Bandlücke und ein zweites Material eine kleinere Bandlücke aufweisen, **gekennzeichnet durch** eine Infrarot-Transmissions-Meßeinrichtung, bei der Infrarotstrahlung verwendet wird, die von den Halbleiterscheiben mit der kleineren Bandlücke absorbiert und von den Halbleiterscheiben mit der größeren Bandlücke noch zumindest teilweise durchgelassen wird.

3. Vorrichtung nach Anspruch 2, **dadurch gekennzeichnet,** daß die Halbleiterscheiben mit der größeren Bandlücke Gallium-Arsenid-Halbleiterscheiben und die Halbleiterscheiben mit der kleineren Bandlücke Silizium-Halbleiterscheiben sind.

4. Vorrichtung nach Anspruch 2 oder 3, **gekennzeichnet durch** Mittel zur Einführung der Infrarotstrahlung von außerhalb des Transportordenbereichs zwischen die in der Transporthorde stehenden Scheiben, durch Mittel zur zweimaligen Umlenkung der Infrarotstrahlung um 90° und durch Mittel zur Führung der Infrarotstrahlung zu einem außerhalb des Transporthordenbereichs befindlichen Detektor (34; 44).

5. Vorrichtung nach einem der Ansprüche 2 bis 4, **gekennzeichnet durch** Lichtleitfasern (36; 46) als Mittel zur Führung des Infrarotstrahls.

6. Vorrichtung nach Anspruch 5, **dadurch gekennzeichnet,** daß die Endfläche (37) mindestens einer Lichtleitfaser (36) unter 45° zur optischen Achse geneigt und verspiegelt ist zur Umlenkung der Infrarotstrahlung um 90°.

7. Vorrichtung nach Anspruch 5, **dadurch gekennzeichnet,** daß das Ende (38) mindestens einer Lichtleitfaser (36) senkrecht zur optischen Achse abgeschnitten ist und daß die Umlenkung der Infrarotstrahlung um 90° durch einen außerhalb der Lichtleitfaser (36) angeordneten 45°-Spiegel (39; 49) erfolgt.

8. Vorrichtung nach einem der Ansprüche 2 bis 7 mit Infrarot-Transmissionsstrecken für jeden Halbleiterscheibenplatz in der Transporthorde (52) zur Abfrage aller dieser Transmissionsstrecken.

## Claims

1. Device for identifying different semiconductor wafers (13, 14) in a carrier tray, characterised by the combination of the carrier tray containing the semiconductor wafers with a mechanical gauge (51) which fits onto the carrier tray and has slots (10) which are not only narrower than the lower tolerance thickness of a first semiconductor wafer type (14) but wider than the upper tolerance thickness of a second semiconductor wafer type (13) in such a way that the semiconductor wafers (13, 14) of the second semiconductor type contained in the carrier tray slip into said slots (10) of the applied gauge (51).

2. Device according to Claim 1, in which the semiconductor wafers consist of different material, of which a first material has a larger band gap and a second material a smaller band gap, characterised by an infrared transmission measuring device in which infrared radiation is used which is absorbed by the semiconductor wafers having the smaller band gap and is at least partially still transmitted by the semiconductor wafers having the larger band gap.

3. Device according to Claim 2, characterised in that the semiconductor wafers with the larger band gap are gallium arsenide semiconductor wafers and the semiconductor wafers with the smaller band gap are silicon semiconductor wafers.

4. Device according to Claim 2 or 3, characterised by means for introducing the infrared radiation between the wafers standing in the carrier tray from outside the region of the carrier tray, by means for twice deflecting the infrared radiation through 90° and by means for conveying the infrared radiation to a detector (34; 44) situated outside the region of the carrier tray.

5. Device according to one of Claims 2 to 4, characterised by optical waveguide fibres (36; 46) as means for conveying the infrared beam.

6. Device according to Claim 5, characterised in that the end face (37) at least of one optical waveguide fibre (36) is inclined at 45° to the optical axis and is metallised in order to deflect the infrared radiation through 90°.

7. Device according to Claim 5, characterised in that the end (38) at least of one optical waveguide fibre (36) is cut off perpendicularly to the optical axis and in that the infrared radiation is deflected through 90° by a 45° mirror (39; 49) disposed outside the optical waveguide fibre (36).

8. Device according one of Claims 2 to 7, having infrared transmission paths for each semiconductor wafer position in the carrier tray (52) for the purpose of scanning all said transmission paths.

## Revendications

1. Dispositif pour identifier des tranches semiconductrices différentes (13,14) dans un ensemble de transport, caractérisé par la combinaison de l'ensemble d'entraînement, qui contient les tranches semiconductrices, et d'un gabarit mécanique (51) adapté à l'ensemble de transport et comportant des fentes (10), qui sont d'une largeur inférieure à l'épaisseur inférieure de tolérance d'un premier type (14) de tranches semiconductrices et également supérieure à l'épaisseur supérieure de tolérance d'un second type (13) de tranches semiconductrices, de sorte que les tranches semiconductrices (13,14) du second type, qui sont situées dans l'ensemble de transport, glissent dans lesdites fentes (10) du gabarit (51) appliqué.

2. Dispositif suivant la revendication 1, dans lequel les tranches semiconductrices sont formées par des matériaux différents, parmi lesquels un premier matériau possède une bande interdite plus importante et un second matériau possède une bande interdite plus faible, caractérisé par un dispositif de mesure de transmission à infrarouge, dans lequel on utilise le rayonnement infrarouge qui est absorbé par des tranches semiconductrices possédant la bande interdite la plus faible et est transmis encore au moins partiellement par des tranches semiconductrices possédant la bande interdite la plus grande.

3. Dispositif suivant la revendication 2, caractérisé par le fait que les tranches semiconductrices possédant la bande interdite la plus grande sont des tranches semiconductrices à base d'arseniure de gallium et les tranches semiconductrices possédant la bande interdite la plus faible sont des tranches semiconductrices à base de silicium.

4. Dispositif suivant la revendication 2 ou 3, caractérisé par des moyens pour introduire le rayonnement infrarouge à partir de l'extérieur de la zone de l'ensemble de transport, entre les tranches situées dans l'ensemble de transport, par des moyens pour faire dévier deux fois le rayonnement infrarouge sur 90°, et par des moyens pour guider le rayonnement infrarouge jusqu'à un détecteur (34;44) situé à l'extérieur de la zone de l'ensemble de transport.

5. Dispositif suivant l'une des revendications 2 à 4, caractérisé par des fibres conductrices de lumière (36;46) en tant que moyens servant à guider le rayonnement infrarouge.

6. Dispositif suivant la revendication 5, caractérisé par le fait que la surface d'extrémité (37) d'au moins une fibre conductrice de lumière (36) est inclinée de 45° par rapport à l'axe optique et est métallisée de manière à dévier sur 90° le rayonnement infrarouge.

7. Dispositif suivant la revendication 5, caractérisé par le fait que l'extrémité (38) d'au moins une fibre conductrice de lumière (36) est sectionnée perpendiculairement à l'axe optique et que la déviation du rayonnement infrarouge sur 90° est produite par un miroir à 45° (39;49) disposé à l'extérieur de la fibre conductrice de lumière (36).

8. Dispositif suivant l'une des revendications 2 à 7 comportant des sections de transmission infrarouge pour chaque emplacement d'une tranche semiconductrice dans l'ensemble de transport (52) pour l'interrogation de toutes ces sections de transmission.

# FIG 1

# FIG 2

32   32   32

35   33   35

31

30   34

# FIG 3

32

37   33   32

36   36

31

30   34

# FIG 4

32

39   33   39

38   38

36   36

30   34

FIG 5

FIG 6

FIG 7

# FIG 8

52

53

51

54

55

55